# EUROPÄISCHE PATENTSCHRIFT

(11) **EP 1 917 711 B1**
(45) Veröffentlichungstag und Bekanntmachung des Hinweises auf die Patenterteilung: **25.03.2009**
(21) Anmeldenummer: 06762140.9
(22) Anmeldetag: 22.06.2006
(51) Int. Cl.: H02M 7/5387

(54) **SCHALTUNGSANORDNUNG UND VERFAHREN ZUM ERZEUGEN VON STEUERSIGNALEN FÜR AUF EINEM HOHEN BEZUGSPOTENTIAL LIEGENDE KOMPONENTEN**
CIRCUIT AND METHOD FOR GENERATING CONTROL SIGNALS FOR COMPONENTS ON A HIGH REFERENCE POTENTIAL
CIRCUIT ET PROCEDE POUR GENERER DES SIGNAUX DE COMMANDE POUR DES ELEMENTS A POTENTIEL DE REFERENCE ELEVE

(30) Priorität: 24.08.2005 DE 102005040062
(43) Veröffentlichungstag der Anmeldung: 07.05.2008
(73) Patentinhaber: TridonicAtco GmbH & Co. KG, 6851 Dornbirn (AT)
(72) Erfinder: MARENT, Günter, A-6780 Bartholomäberg (AT); ZUDRELL-KOCH, Stefan, A-6845 Hohenems (AT)
(74) Vertreter: Rupp, Christian
(86) Internationale Anmeldenummer: PCT/EP2006/006025
(87) Internationale Veröffentlichungsnummer: WO 2007/022822

(56) Entgegenhaltungen:
- US-A- 5 666 280
- US-A- 5 767 631
- US-A1- 2003 042 967
- YAN YIN ET AL: "Dual low voltage IC based high and low side gate drive" APPLIED POWER ELECTRONICS CONFERENCE AND EXPOSITION, 2004. APEC '04. NINETEENTH ANNUAL IEEE ANAHEIM, CA, USA 22-26 FEB. 2004, PISCATAWAY, NJ, USA,IEEE, Bd. 2, 22. Februar 2004 (2004-02-22), Seiten 1033-1038, XP010703524 ISBN: 0-7803-8269-2

## Beschreibung

Die vorliegende Erfindung betrifft eine Schaltungsanordnung zum Erzeugen von Steuersignalen beispielsweise für die Ansteuerung eines Leistungsschalters, der auf einem hohen Bezugspotential liegt. Insbesondere betrifft die vorliegende Erfindung das Problem des Ansteuerns eines auf dem höheren Potential liegenden Leistungsschalters einer Halb- oder Vollbrückenanordnung, die beispielsweise zur Verwendung in einem elektronischen Vorschaltgerät zum Betreiben einer Gasentladungslampe vorgesehen ist.

Zum Betreiben von Gasentladungslampen werden heutzutage überwiegend sogenannte elektronische Vorschaltgeräte eingesetzt, da diese Geräte im Vergleich zu konventionellen Lampenbetriebsgeräten einen zuverlässigeren und sicheren Lampenbetrieb ermöglichen. Generell basieren elektronische Vorschaltgeräte auf dem Prinzip, dass eine mit Hilfe einer Zwischenkreisschaltung generierte Gleichspannung mit Hilfe eines Wechselrichters in eine hochfrequente Versorgungsspannung für den die Lampe enthaltenden Lastkreis umgesetzt wird. Üblicherweise werden zur Realisierung des Wechselrichters Leistungsschalter eingesetzt, die in einer Halb- oder Vollbrückenanordnung angeordnet sind.

Bei nahezu jedem Vorschaltgerät stellt sich dann das Problem, dass zumindest einer der Leistungsschalter zum Erzeugen der Lampenversorgungsspannung, der in der Regel durch einen Power-MOSFET gebildet wird, auf einem hohen Potential liegt. Da auf der anderen Seite die Steuereinheit zum Generieren der Signale für die Ansteuerung der Leistungsschalter auf einem deutlich niedrigeren Potential liegt, sind besondere Maßnahmen erforderlich, um das von der massebezogenen Steuereinheit generierte Steuersignal auf die Bezugsspannung für den Leistungsschalter anzuheben.

Zur Lösung dieses Problems sind unterschiedlichste Vorschläge gemacht worden, die allerdings im wesentlichen auf dem Gedanken beruhen, separate Komponenten und Schaltelemente einzusetzen, um den Leistungsschalter anzusteuern. Hierdurch werden allerdings der Aufwand zur Realisierung des Vorschaltgeräts sowie die damit verbundenen Kosten erhöht. Ein weiterer Nachteil besteht darin, dass die bislang bekannten und eingesetzten Lösungen nicht dazu geeignet sind, in die Steuereinheit des elektronischen Vorschaltgeräts integriert zu werden.

Der vorliegenden Erfindung liegt dementsprechend die Aufgabe zugrunde, eine neuartige und kostengünstige Lösung zur Übertragung eines Steuersignals für die Ansteuerung eines auf einem hohen Bezugspotential liegenden Schalters anzugeben. Dabei soll der Aufwand zum Erzeugen des Steuersignals möglichst gering gehalten werden.

Die Aufgabe wird durch die in den unabhängigen Ansprüchen definierte Erfindung gelöst. Vorteilhafte Weiterbildungen der Erfindung sind Gegenstand der Unteransprüche.

Die erfindungsgemäße Lösung beruht zunächst auf der Idee, bereits bekannte und genutzte Technologien einzusetzen und in einer besonderen Art und Weise miteinander zu kombinieren, derart, dass eine einfache aber effektive Ansteuerung des auf dem hohen Potential liegenden Leistungsschalters ermöglicht wird. Es handelt sich hierbei um Komponenten bzw. Technologien, die teilweise ohnehin bereits in elektronischen Vorschaltgräten vorgesehen waren, allerdings bislang lediglich isoliert zur Lösung anderer, sehr spezieller Aufgabenstellungen genutzt wurden.

Ein erstes Element, welches Bestandteil der vorliegenden Erfindung ist, ist dabei ein sogenannter Snubber-Kondensator, dessen Aufgabe es üblicherweise ist, während der Ansteuerung des Lastkreises des Vorschaltgeräts in der Phase, in der beide Schalter der Halbbrücke geöffnet sind, einen Stromfluss zu ermöglichen. Hierdurch wird ein sogenannter ZVS (Zero Voltage Switching) Betrieb, also das spannungslose Wiedereinschalten der Leistungsschalter ermöglicht, wodurch die Belastung für diese Schalter reduziert werden kann. Dieser Snubber-Kondensator wurde bislang ferner auch dazu genutzt, eine Niedervoltversorgung zu Verfügung zu stellen, die von den elektronischen Komponenten des Vorschaltgeräts als Versorgungsspannungsquelle genutzt werden konnte.

Ein zweiter Bestandteil der erfindungsgemäßen Lösung beruht auf dem Einsatz einer als kapazitiver Level-Shifter bezeichneten Schaltungsvariante. Zentraler Bestandteil eines derartigen kapazitiven Level-Shifters ist wiederum ein Kondensator, der zur Anhebung eines auf einem niedrigen Potential liegenden Signals auf ein hohes Potential genutzt wird. Hierzu werden die beiden Anschlüsse des Kondensators derart mit hochohmigen Komponenten verschaltet bzw. verbunden, dass sich die an dem Kondensator anliegende Ladung kurzfristig nicht verändern kann. Wird nunmehr ein an dem Kondensatoranschluß, der auf dem niedrigen Potential liegt, anliegendes Signal verändert, so erfolgt parallel hierzu auch eine Verschiebung des auf der anderen Seite des Kondensators anlegenden Potentials, welches dann als Steuersignal genutzt werden kann, das auf einem höheren Bezugspotential liegt.

Die erfindungsgemäße Lösung beruht nunmehr auf dem Gedanken, beide zuvor beschriebenen Komponenten, den Snubber-Kondensator einerseits und den kapazitiven Level-Shifter andererseits zu vereinigen, um eine Anhebung der von einer massebezogenen Steuerschaltung generierten Steuersignale auf ein höheres Bezugspotential zu ermöglichen. Der bei einem elektronischen Vorschaltgerät üblicherweise ohnehin bereits vorhandene Snubber-Kondensator wird hierbei mittels zusätzlicher Schaltungselemente derart verschaltet, dass er gleichzeitig auch als Bestandteil eines kapazitiven Level-Shifters eingesetzt werden kann, um die Anhebung des Steuersignals in der gewünschten Weise zu bewirken. Zusätzlich kann mit Hilfe der erfindungsgemäßen Schaltungsanordnung der Snubber-Kondensator auch zur Bereitstellung von Versorgungsspannungen für die verschiedenen Komponenten genutzt werden, so dass er letztendlich die folgenden vier unterschiedlichen Aufgaben erfüllt:
- Isolation zwischen den auf einem niedrigen Potential liegenden Komponenten einerseits und den Komponenten, die auf einem hohen Bezugspotential liegen, andererseits;
- Anhebung von Steuersignalen auf ein höheres Bezugspotential zur Ansteuerung des Leistungsschalters;
- Generierung von Versorgungsspannungen;
- Gewährleistung des Zero Voltage Switching-Betriebs.

Ein ähnlicher Lösungsvorschlag ist bereits aus der Veröffentlichung "Dual Low Voltage IC Based High and Low Side Gate Drive" von Yan Yin und Regan Zane, Proceedings IEEE Applied Power Electronics Conference and Exposition, Feb. 2004, S. 10333-1038 bekannt. In dieser Veröffentlichung wird eine Schaltungsvariante vorgeschlagen, bei welcher aufgrund der Ansteuerung eines Kondensators durch zu beiden Seiten des Kondensators befindliche Treiberschaltungen alternierende Stromflüsse hervorgerufen werden, durch welche u.A. ein Ansteuern des auf dem hohen Potential liegenden Schalters einer Halbbrücke bewirkt wird.

Gegenüber dieser bekannten Schaltungsvariante ist nunmehr allerdings vorgesehen, dass der Snubber- bzw. Kondensator dazu genutzt wird, ein eigenständig generiertes Steuersignal anzuheben bzw. zu transformieren, um ein Signal für die Ansteuerung des auf dem hohen Leistungspotential liegenden Schalters zu bilden. Hierdurch besteht eine deutlich größere Flexibilität bei der Nutzung von Steuersignalen für den Betrieb des Wechselrichters. Insbesondere eröffnet die erfindungsgemäße Lösung die Möglichkeit, sowohl digitale als auch analoge Steuersignale zu nutzen.

Wie anhand der später noch näher erläuterten Ausführungsbeispiele ersichtlicht ist, zeichnet sich die erfindungsgemäße Lösung ferner dadurch aus, dass die oben genannten Funktionen ohne den Einsatz einer Vielzahl zusätzlicher Komponenten ermöglicht werden. Stattdessen ist eine verhältnismäßig einfache Erweiterung bereits genutzter Schaltungsanordnungen ausreichend, um die angestrebte Lösung zu realisieren. Hierbei ist insbesondere gewährleistet, dass eine Integration der verschiedenen Komponenten ermöglicht ist.

Das mit Hilfe der erfindungsgemäßen Schaltungsanordnung generierte Signal kann dann beispielsweise unmittelbar zum Ansteuern des auf dem hohen Bezugspotential liegenden Leistungsschalters einer Halbbrücke eines elektronischen Vorschaltgeräts genutzt werden. Alternativ dazu bestünde allerdings auch die Möglichkeit, zunächst eine Serienschaltung bestehend aus einem PNP-Transistor und einem NPN-Transistor anzusteuern, wobei das am Verbindungspunkt der beiden Transistoren entstehende Signal dann das Steuersignal für den auf dem hohen Potential liegenden Schalter bildet. Wie später noch näher erläutert wird, wird auf diese Weise eine besonderes elegante Lösung zum Ansteuern beider Schalter eines Wechselrichters geschaffen.

Die tatsächliche Ausgestaltung der erfindungsgemäßen Schaltungsanordnung kann in unterschiedlicher Art und Weise erfolgen. Hierbei wäre es zunächst denkbar, die verschiedenen Schaltungselemente zur Realisierung der verschiedenen Betriebsarten des Snubber-Kondensators durch steuerbare Schalter zu bilden. Gemäß einem zweiten Aspekt der vorliegende Erfindung wird allerdings vorgeschlagen, diese Schaltelemente zumindest teilweise durch Dioden, beispielsweise durch Z-Dioden zu bilden.

Nachfolgend soll die Erfindung anhand der beiliegenden Zeichnung näher erläutert werden. Es zeigen:
- Figur 1: die Ausgestaltung eines elektronischen Vorschaltgeräts gemäß dem Stand Technik;
- Figur 1a: verschiedene Strom- und Spannungsverläufe bei dem bekannten Vorschaltgerät von Figur 1;
- Figur 2: die Nutzung eines Snubber- Kondensators als Niedervolt- versorgungsquelle;
- Figur 3: ein Schema zur Verdeutlichung der Funktionsweise eines kapazitiven Level- Shifters;
- Figur 3a: die Signalverläufe bei dem kapazitiven Level-Shifter von Figur 3;
- Figur 4: ein generelles Schema einer erfindungsgemäß ausgeschalteten Schaltungsanordnung;
- Figur 5: ein erstes bevorzugtes Ausführungsbeispiel zur Realisierung der erfindungsgemäßen Schaltungsanordnung;
- Figur 5a: die Signalverläufe bei dem Ausführungsbeispiel von Figur 5, und
- Figur 6: ein zweites bevorzugtes Ausführungsbeispiel zur Realisierung der erfindungsgemäßen Schaltungsanordnung.

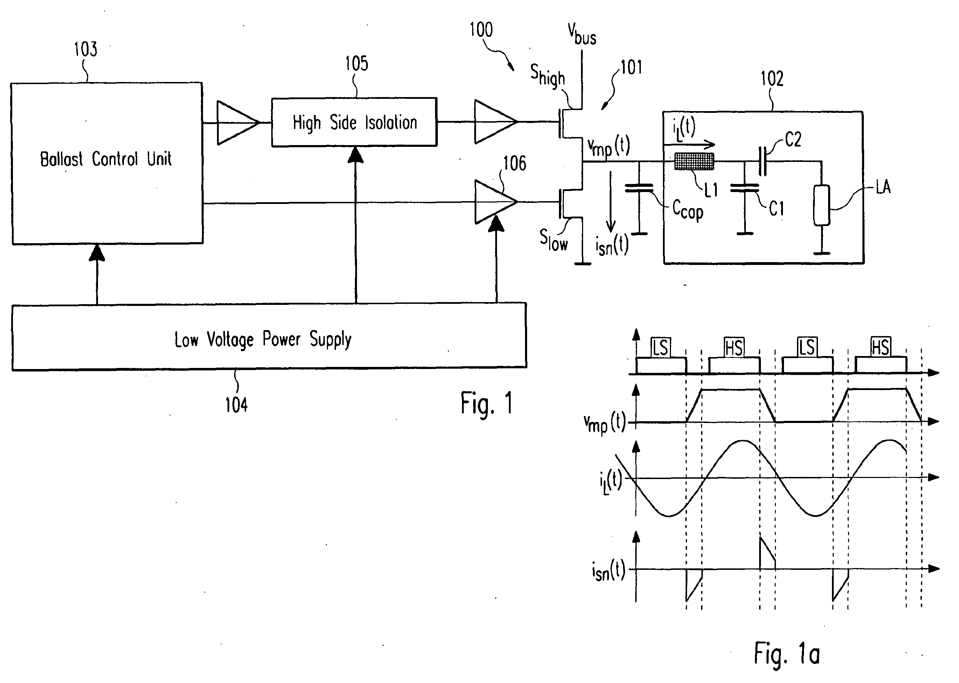

Bevor die erfindungsgemäße Schaltungsanordnung näher erläutert wird, soll zunächst anhand eines bekannten elektronischen Vorschaltgeräts, wie es in Figur 1 dargestellt ist, das der vorliegenden Erfindung zugrunde liegende Problem nochmals erläutert werden.

Figur 1 zeigt hierzu ein allgemein mit dem Bezugszeichen 100 versehenes elektronisches Vorschaltgerät, dessen Hauptbestandteil ein Wechselrichter 101 bestehend aus zwei in einer Halbbrückenanordnung verschalteten Leistungsschaltern S_{high} und S_{low} ist, der dazu dient, aus einer Gleichspannung V_{bus} eine Versorgungsspannung für einen an den Ausgang des Wechselrichters 101 angeschlossenen Lastkreis 102, der die Lampe LA beinhaltet, zu bilden. Der Lastkreis 102 weist in bekannter Weise einen aus einer Induktivität L1 und einer Kapazität C1 gebildeten Serienresonanzkreis sowie einen Kondensator C2 auf. Durch alternierendes Ansteuern der beiden Leistungsschalter S_{high} und S_{low} wird der Lastkreis 102 induktiv mit einer hochfrequenten Wechselspannung betrieben, wobei durch Veränderung der Frequenz der Wechselspannung die Leistung für die Lampe LA in bekannter Weise gesteuert werden kann.

Dabei ist vorzugsweise vorgesehen, dass der untere Leistungsschalter S_{low} zu einem Zeitpunkt eingeschaltet wird, zu dem die Spannung auf Null abgefallen ist. Durch diesen sogenannten ZVS (Zero Voltage Switching) Betrieb wird die Belastung für dies Leistungsschalter reduziert. Um dies zu gewährleisten, ist parallel zu dem Lastkreis 102 ein sogenannter Snubber-Kondensator C_{cap} angeordnet, der in einer Phase, in der beide Schalter S_{high} und S_{low} der Halbbrücke 101 geöffnet sind, einen Stromfluß iₛₙ(t) und damit ein Abfallen der Spannung vₘₚ(t) am Ausgang der Halbbrücke auf Null ermöglicht, wie die verschiedenen in Figur 1a dargestellten Strom- und Spannungsverläufe zeigen. Letztendlich wird auf diese Weise ein hochfrequenter Wechselstrom i_{L}(t) erzeugt, mit dem die Lampe LA betrieben wird.

Die alternierende Ansteuerung der beiden Schalter S_{high} und S_{low} der Halbbrücke 101 erfolgt durch eine Steuerschaltung 103, die Ausgangssignale zum Ansteuern der beiden Schalter S_{high} und S_{low} erzeugt. Das für den auf dem niedrigen Potential liegenden unteren Schalter S_{low} abgegebene Steuersignal kann dabei diesem unmittelbar bzw. über eine einfache Treiberschaltung 106 übermittelt werden. Gleiches ist für den auf dem höheren Potential liegenden Schalter S_{high} hingegen nicht möglich, da die Steuereinheit 103 im Vergleich zu dem Leistungsschalter S_{high} auf einem niedrigeren Bezugspotential liegt. Dementsprechend sind besondere Mittel 105 zur Isolierung zwischen den Einheiten auf dem niedrigen Bezugspotential und dem auf dem höheren Potential liegenden Schalter S_{high} erforderlich. Aufgabe der nachfolgend beschriebenen Erfindung ist es, diese Maßnahmen zur Isolierung möglichst gering zu halten, um den Aufwand zur Realisierung der Schaltungsanordnung zu reduzieren. Ferner sollte auch der Aufwand zur Stromversorgung der aktiven Komponenten der Schaltungsanordnung reduziert werden. In Figur 1 ist hierzu eine separate Niedervoltversorgungsquelle 104 dargestellt, welche die verschiedenen Einheiten versorgt.

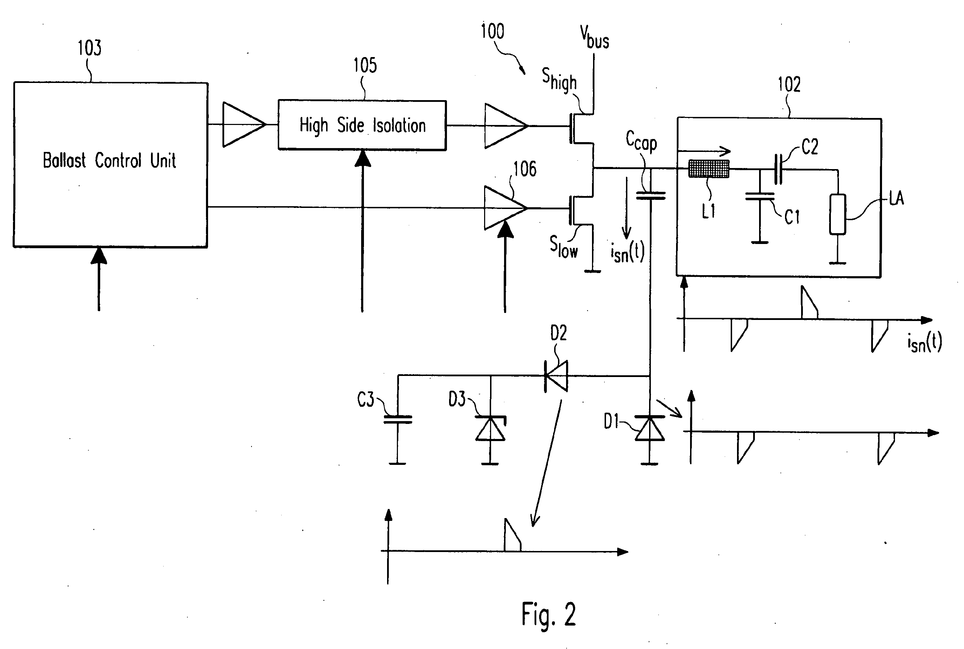

Ein erster Gedanke der erfindungsgemäßen Lösung beruht darauf, den Snubber-Kondensator C_{cap} zusätzlich auch zur Spannungsversorgung für die verschiedenen Komponenten der Schaltungsanordnung zu nutzen. Hierzu wird auf ein Schaltungskonzept zurückgegriffen, welches in Figur 2 dargestellt ist und ebenfalls bereits bekannt ist. Figur 2 zeigt dabei wiederum Teile eines elektronisches Vorschaltgerät, wobei gleiche Komponenten wie in Figur 1 mit dem gleichen Bezugszeichen versehen sind.

Zur Nutzung des Snubber-Kondensators C_{cap} als ergänzende Niedervoltversorgungsquelle ist dieser nunmehr nicht unmittelbar mit Masse bzw. dem Bezugspotential verschaltet, sondern stattdessen an eine spezielle Schaltungsanordnung bestehend aus zwei Dioden D1 und D2, einer Z-Diode D3 sowie einem Speicherkondensator C3 angeschlossen. Entsprechend den obigen Erläuterungen fließt über den Snubber-Kondensator C_{cap} in den Zeiträumen, in denen beide Schalter S_{high} und S_{low} der Halbbrücke 101 geöffnet sind, ein Strom, dessen Richtung wechselt. Durch die spezielle Verschaltung des einen Endes des Snubber-Kondensators C_{cap} mit den beiden Dioden D1 und D2 fließt also in regelmäßigen Abständen über die Diode D2 ein Strom, durch welchen der Speicherkondensator C3 aufgeladen wird. Die an diesem Speicherkondensator C3 anliegende Spannung kann nunmehr zur Niedervoltversorgung für die verschiedenen Komponenten des Vorschaltgeräts 100 genutzt werden. Dieser Gedanke war - wie bereits erwähnt - schon bekannt und wurde auch in elektronischen Vorschaltgeräten eingesetzt.

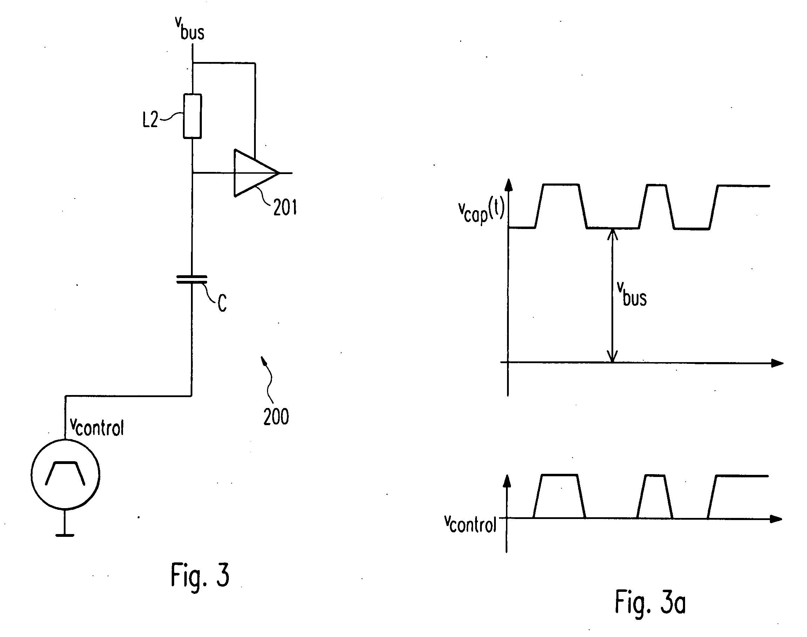

Eine zweite wesentliche Komponente der vorliegenden Erfindung besteht in der Verwendung eines sogenannten kapazitiven Level-Shifters, der in Figur 3 dargestellt ist. Aufgabe dieses allgemein mit dem Bezugszeichen 200 versehenen kapazitiven Level-Shifters ist es, ein auf einem niedrigen Potential liegenden Kontrollsignal V_{control} anzuheben, um beispielweise die Ansteuerung eines auf einem hohen Bezugspotential liegenden Elements zu ermöglichen. Zentrales Element des kapazitiven Level-Shifters 200 ist wiederum ein Kondensator C, dessen einer Anschluss mit einer Einrichtung zur Generierung des Steuersignals V_{control} verbunden ist und dessen anderer Anschluss mit einer Busspannung V_{bus} gespeist wird. Hierbei ist dieses andere Ende des Kondensators C über zwei weitere Komponenten an L2 und 201 die Busspannung V_{bus} angeschlossen, wobei diese beiden weiteren Komponenten L2 und 201 nunmehr allerdings hochohmig ausgestaltet sind. Dies hat zur Folge, dass bei einer kurzfristigen Änderung des Potentials auf einer Seite des Kondensators C kein Ladungsausgleich stattfinden kann, sondern stattdessen das Potential auf der anderen Seite des Kondensators C in gleicher Weise modifiziert wird. Wie dementsprechend den Signalverläufen in Figur 3a entnommen werden kann, führt dies dazu, dass die am oberen Anschluss des Kondensators anliegende Spannung V_{cap}(t) dem Steuersignal V_{control} folgt, allerdings um die Höhe der Bus-Spannung V_{bus} angehoben wurde.

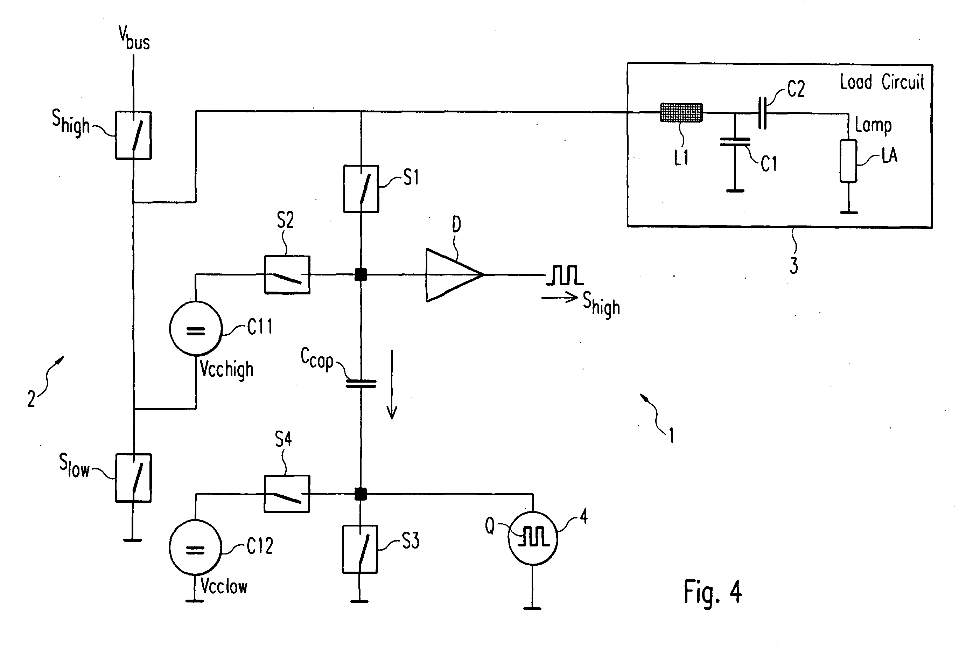

Die erfindungsgemäße Lösung beruht nunmehr darauf, die Funktionen des Snubber-Kondensators sowie des kapazitiven Level-Shifters zu vereinigen, um zu einer Schaltungsanordnung zu gelangen, welche auf einfache Weise die Erzeugung von Steuersignalen für ein auf einem hohen Potential liegendes Bauteil, insbesondere für einen Leistungsschalter ermöglicht. Die sich hierbei grundsätzlich ergebende Konfiguration der erfindungsgemäßen Schaltungsanordnung 1 ist in Figur 4 dargestellt.

Gezeigt ist in Figur 4 wiederum ein die beiden Leitungsschalter S_{high} und S_{low} aufweisender Wechselrichter 2, an dessen Ausgangsanschluss zunächst der Lastkreis 3 mit der Lampe LA angeordnet ist. Zentrale Elemente der erfindungsgemäßen Schaltungsanordnung 1 sind nunmehr ferner der Kondensator C_{cap} sowie Komponenten zur Bereitstellung von Versorgungsspannungen, wobei die in Figur 2 gezeigten und zur Bereitstellung der Niedervoltversorgung genutzten Komponenten gespiegelt in gleicher Weise auch auf der anderen Seite des Kondensators C_{cap} angeordnet sind. Generell weist die Schaltungsanordnung also zunächst den Snubber- bzw. Koppelkondensator C_{cap} sowie zwei Schaltelemente S1 und S2 auf, über welche der obere Anschluss des Kondensators C_{cap} wahlweise unmittelbar mit dem Ausgang der Halbbrücke 2 oder über ein ersten Speicherkondensator C11 zur Bereitstellung einer ersten Versorgungsspannung V_{cchigh} verbunden werden kann. Darüber hinaus sind weitere Schaltelemente S3 und S4 vorgesehen, über die der andere Anschluss des Kondensators C_{cap} wahlweise entweder unmittelbar mit dem Bezugspotential oder über einen zweiten Speicherkondensator C12 mit Masse verbunden werden kann, wobei der zweite Speicherkondensator C12 wiederum zur Bereitstellung einer zweiten Niedervoltversorgungsspannung V_{cclow} nutzbar ist.

Die vier Schaltelemente S1 bis S4 werden nun derart angesteuert, dass der Kondensator C_{cap} auf der einen Seite als Snubber-Kondensator sowie zur Verfügungstellung der verschiedenen Versorgungsspannungen V_{cchigh} und V_{cclow} genutzt werden kann. Auf der anderen Seite wird der Kondensator C_{cap} als Bestandteil eines kapazitiven Level-Shifters eingesetzt, um die Generierung von auf einem hohen Bezugspotential liegenden Steuersignalen zu ermöglichen, welche insbesondere zur Ansteuerung des oberen Leistungsschalters S_{high} genutzt werden können. Diese verschiedenen Betriebsarten des Kondensator C_{cap} werden durch eine geeignete Steuerung der Schaltelemente S1 bis S4 ermöglicht, wie nachfolgend erläutert wird.

Die Funktionsweise als Snubber-Kondensator liegt dann vor, wenn in einer Phase, in der die beiden Leistungsschalter S_{high} und S_{low} der Halbbrücke 2 geöffnet sind, eines der beiden Schaltelemente S1 oder S2 sowie eines der beiden Schaltelemente S3 und S4 geschlossen sind. In dieser Phase wird dann also ein Stromfluss über den Snubber-Kondensator C_{cap} ermöglicht, der zu dem bevorzugten ZVS-Betrieb führt. Gleichzeitig führt dieser Stromfluss auch dazu, dass jeweils einer der beiden Speicherkondensatoren C11, C12 aufgeladen wird, um dann letztendlich die Versorgungsspannungen V_{cchigh} und V_{cclow} zur Verfügung zu stellen.

Werden hingegen die vier Schaltelemente S1 bis S4 geöffnet, so ergibt sich die Funktion eines kapazitiven Level-Shifters. Das von einer auf einem niedrigen Bezugspotential liegenden Steuereinrichtung 4 erzeugte Steuersignal Q wird nunmehr über den hochohmig angebundenen Kondensator C_{cap} angehoben und als auf einem hohen Bezugspotential liegendes Signal an das Entkoppelelement D übertragen. Der Ausgang dieses Entkoppelelement D stellt dann letztendlich das Steuersignal zur Ansteuerung des Leistungsschalters zur Verfügung.

Insgesamt wird also eine sehr elegante Lösung geschaffen, um das Steuersignal zur Ansteuerung des oberen Leistungsschalters S_{high} zur Verfügung zu stellen. Hierbei ist insbesondere von Bedeutung, dass der Koppelkondensator C_{cap} sowie der zweite Speicherkondensator C12 ohnehin bereits üblicherweise Bestandteile eines elektrischen Vorschaltgeräts sind, so dass der Mehraufwand zur Realisierung der erfindungsgemäßen Schaltungsanordnung 1 äußerst gering ist. Wie nachfolgend noch näher gezeigt ist, besteht dabei insbesondere die Möglichkeit, Komponenten zur Realisierung der verschiedenen Schaltelemente einzusetzen, welche eine weitestgehende Integration ermöglichen. Hierdurch werden die Kosten zur Herstellung des Vorschaltgeräts deutlich reduziert.

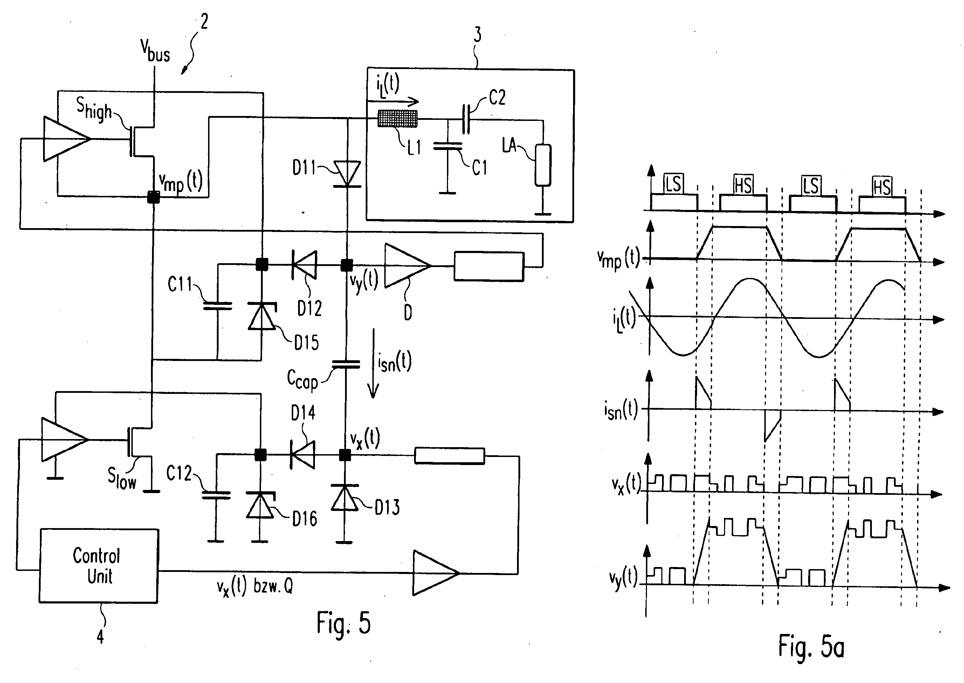

Figur 5 zeigt nunmehr ein erstes Ausführungsbeispiel zur Realisierung der erfindungsgemäßen Schaltungsanordnung. Die Besonderheit dieses ersten Ausführungsbeispiels besteht darin, dass die Schaltelemente S1 bis S4 durch Dioden D11 bis D14 gebildet sind. Hierdurch ergibt sich der besondere Vorteil, dass auf den Einsatz aktiver Elemente weitestgehend verzichtet werden kann. Hinsichtlich seines weiteren Aufbaus entspricht dieses erste Ausführungsbeispiel der Konzeptdarstellung in Figur 4, wobei allerdings parallel zu den jeweiligen Speicherkondensatoren C11 und C12 nunmehr zusätzlich eine Z-Diode angeordnet ist. Dieses erstes konkrete Ausführungsbeispiel verdeutlicht sehr gut, dass der Aufwand zur Realisierung der erfindungsgemäßen Schaltungsanordnung äußerst gering ist, da im Wesentlichen lediglich die oberen beiden Dioden D11 und D12, der ober Speicherkondensator C11 sowie die obere Z-Diode D15 hinzugefügt werden müssen. Die an den unteren Anschluß des Kondensators C_{cap} angeschlossenen Komponenten hingegen sind bereits Bestandteile eines klassischen elektronischen Vorschaltgeräts.

Die Dioden D15 bzw. D16 können indessen weggelassen werden, wenn die Dioden D11 bzw. D13 jeweils als Z-Dioden ausgebildet sind.

Die sich bei diesem ersten Ausführungsbeispiel ergebenden Strom- und Spannungsverläufe sind in Figur 5a dargestellt, wobei insbesondere der Darstellung entnommen werden kann, dass das von der massebezogenen Steuereinheit 4 generierte Ausgangssignal vₓ(t) während der Phasen, in denen der Kondensators C_{cap} die Funktion eines Level-Shifters erfüllt, wie gewünscht auf ein höheres Ausgangssignal v_{y}(t) angehoben wird, allerdings hinsichtlich seines Verlaufs gleicht bleibt.

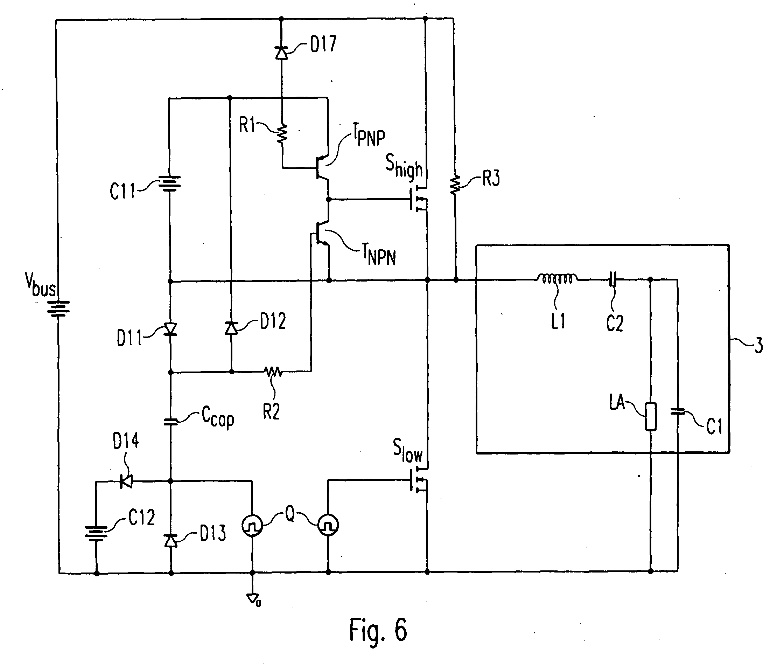

Ein zweites Ausführungsbeispiel der erfindungsgemäßen Schaltungsanordnung ist schließlich in Figur 6 gezeigt, wobei wiederum gleiche Elemente mit den gleichen Bezugszeichen versehen sind.

Die Besonderheit dieser zweiten Ausführungsform besteht darin, dass im Wesentlichen mit analogen Komponenten die gewünschte Ansteuerung der Leistungsschalter S_{high} und S_{low} der Halbbrücke 2 erzielt wird. Bei dem Ausführungsbeispiel gemäß Figur 6 werden die vier Schaltelemente zum Steuern des Betriebsverhaltens des Snubber-Kondensators C_{cap} wieder durch vier Dioden D11 bis D14 gebildet. Eine Besonderheit besteht nunmehr allerdings in der Generierung des Ansteuersignals für den oberen Leistungsschalter S_{high}, wozu zusätzlich eine Serienschaltung aus einem NPN-Transistor T_{NPN} und einem PNP-Transistor T_{PNP} eingesetzt wird. An der Verbindungsstelle zwischen beiden Transistoren T_{NPN}, T_{PNP} wird das Ansteuersignal für den oberen Leistungsschalter S_{high} generiert.

Die Kondensatoren C11 und C12 weisen in der gezeigten Schaltung die Funktion von Spannungsquellen auf und sind daher auch schematisch mit dem Symbol für eine Spannungsquelle dargestellt.

Die Funktionsweise dieses zweiten Ausführungsbeispiels ist wie folgt:

Nach einem Öffnen der beiden Leistungsschalter S_{high} und S_{low} der Halbbrücke 2 wird die hochliegende Niedervoltversorgung aufgrund der Entladung über den Snubber-Kondensator C_{cap} weiter angehoben und nimmt schließlich einen Wert an, der etwa 15 Volt oberhalb der Busspannung V_{bus} in Höhe von 400 Volt liegt. Dies hat zur Folge, dass über die Serienschaltung aus Diode D17 und Widerstand R1 ein Basisstrom hervorgerufen wird. Durch diesen Strom wird der PNP-Transistor T_{PNP} eingeschaltet, was wiederum zur Folge hat, dass der obere Leistungsschalter S_{high} aktiviert, also leitend geschaltet wird.

Nach Aktivieren des oberen Leitungsschalters erfüllt der Snubber-Kondensator C_{cap} durch die Verschaltung mit den Dioden D11 bis D14 die bereits zuvor beschriebene Funktion des Level-Shifters, da er nun hochohmig mit dem Ausgang des Wechselrichters verbunden ist. Wird also nunmehr ein auf einem niedrigen Potential liegendes Steuersignal Q generiert, mit dem der obere Schalter wieder ausgeschaltet werden soll, so führt die Anhebung des Steuersignals Q durch den kapazitiven Level-Shifter dazu, dass der NPN-Transistor T_{NPN} leitend geschaltet und dementsprechend der obere Leistungsschalter S_{high} der Halbbrücke wieder deaktiviert wird. Da der Snubber-Kondensator C_{cap} allerdings lediglich für einen verhältnismäßig kurzen Zeitraum die Übertragung des Steuersignals Q auf das hohe Potential ermöglicht, sorgt ein weiterer Vorgang dafür, dass der obere Schalter dauerhaft S_{high} deaktiviert bleibt. Dies ist darauf zurückzuführen, dass nach dem Öffnen beider Schalter S_{high} und S_{low} vom Lastkreis 3 wieder Strom zurückfließt, was den Effekt nach sich zieht, dass der Ausschaltimpuls zusätzlich verstärkt wird.

Bei dem zweiten Ausführungsbeispiel wird also eine Lösung dargestellt, bei welcher der obere Schalter S_{high} der Halbbrücke 2 selbstständig eingeschaltet wird, was darauf zurückzuführen ist, dass in der Phase, in der beide Schalter S_{high} und S_{low} der Halbbrücke 2 geöffnet sind, Strom aus dem Lastkreis 3 zurückfließt und bewirkt, dass die hochliegende Niedervoltversorgung über die Busspannung angehoben wird. Das Steuersignal Q wird dementsprechend ausschließlich dazu benötigt, den oberen Leistungsschalter wieder auszuschalten.

Anzumerken ist, dass das Vorsehen der Widerstände R1, R2 und R3 rein fakultativ ist.

Es wird somit eine äußerst elegante Lösung zur Ansteuerung der beiden Schalter der Halbbrücke geschaffen. Bemerkenswerte hierbei ist insbesondere, dass auf derjenigen Seite der Schaltungsanordnung, die auf dem hohen Potential, keine aktiven Elemente eingesetzt werden müssen.

Dieser Aspekt der Erfindung ist im übrigen unabhängig vom dem Snubber-Kondensator und daher auch in anderen Schaltungen vorteilhaft verwendbar.

Insgesamt wird somit eine sehr effektive Lösung geschaffen, Steuersignale zum Ansteuern eines auf einem hohen Bezugspotential liegenden Elements zu erzeugen. Hierbei ist zu bemerken, dass es nicht zwingend erforderlich ist, die angehobenen Signale unmittelbar zum Ansteuern eines Schalters einzusetzen. Denkbar wäre es beispielsweise auch, Steuersignale lediglich auf ein höheres Potential anzuheben und dann in geeigneter Weise weiterzuverarbeiten. In jedem Fall bietet die vorliegende Erfindung die Möglichkeit, die zur Lösung der Aufgabenstellung genutzten Komponenten bzw. Bauteile zu integrieren, was deutliche Vorteile im Hinblick auf den Aufwand zur Herstellung der Schaltungsanordnung sowie den damit verbunden Kosten mit sich bringt.

## Patentansprüche

1. Schaltungsanordnung (1) zum Erzeugen bzw. Übermitteln von Steuersignalen (Q) für einen Wechselrichter (2), der zumindest einen auf einem hohen Potential liegenden ersten Schalter (S_{high}) sowie einen auf einem niedrigen Potential liegenden zweiten Schalter (S_{low}) aufweist, wobei ein Verbindungspunkt zwischen beiden Schaltern (S_{high}, S_{low}) den Ausgang des Wechselrichters (2) bildet,
und wobei die Schaltungsanordnung (1) einen Kondensator (C_{cap}) aufweist, welcher
a) in einer ersten Betriebsphase über Schaltelemente (S1-S4) derart mit dem Ausgang des Wechselrichters (2) verbunden ist, dass er in einem Zustand, in dem beide Schalter (S_{high}, S_{low}) des Wechselrichters (2) geöffnet sind, einen Stromfluß ermöglicht, und **dadurch gekennzeichnet, dass**
b) in einer zweiten Betriebsphase der kondensator über die Schaltelemente (S1-S4) hochohmig mit dem Wechselrichterausgang verbunden ist, so dass ein an einer Seite des Kondensators (C_{cap}) von einer Steuereinrichtung angelegtes Steuersignal (Q) auf ein höheres Potential transformiert wird.

2. Schaltungsanordnung nach Anspruch 1,
**dadurch gekennzeichnet,**
**dass** zumindest eines der Schaltelemente (S1-S4) durch eine Diode (D11-D14) oder eine Z-Diode gebildet ist.

3. Schaltungsanordnung (1) zum Erzeugen bzw. Übermitteln von Steuersignalen (Q) für einen Wechselrichter (2), der zumindest einen auf einem hohen Potential liegenden ersten Schalter (S_{high}) sowie einen auf einem niedrigen Potential liegenden zweiten Schalter (S_{low}) aufweist, wobei ein Verbindungspunkt zwischen beiden Schaltern (S_{high}, S_{low}) den Ausgang des Wechselrichters (2) bildet,
und wobei die Schaltungsanordnung (1) einen Kondensator (C_{cap}) aufweist, welcher
a)in einer ersten Betriebsphase über Schaltelemente (S1-S4) derart mit dem Ausgang des Wechselrichters (2) verbunden ist, dass er in einem Zustand, in dem beide Schalter (S_{high}, S_{low}) des Wechselrichters (2) geöffnet sind, einen Stromfluß ermöglicht, und **dadurch gekennzeichnet, dass**
b) in einer zweiten Betriebsphase der kondensator über die Schaltelemente (S1-S4) hochohmig mit dem Wechselrichterausgang verbunden ist, so dass ein an
einer Seite des kondensators (C_{cap}) von einer Steuereinrichtung angelegtes Steuersignal (Q) auf ein höheres Potential transformiert wird, welches transformierte Signal als Steuersignal für den Wechselrichter (2) nutzbar ist, und
dass zumindest eines der Schaltelemente (S1-S4) durch eine Diode (D11-D14) oder eine Z-Diode gebildet ist.

4. Schaltungsanordnung nach einem der vorherigen Ansprüche,
**dadurch gekennzeichnet,**
**dass** das transformierte Signal (Q) unmittelbar zum Ansteuern des auf dem hohen Potential liegenden Schalters (S_{high}) des Wechselrichters (2) genutzt wird.

5. Schaltungsanordnung nach einem der Ansprüche 1 bis 3,
**dadurch gekennzeichnet,**
**dass** das an dem auf dem höheren Potential liegenden Anschluß des Kondensators (C_{cap}) gebildete Signal zum Ansteuern einer Serienschaltung bestehend aus einem PNP-Transistor (T_{PNP}) und einem NPN-Transistor (T_{NPN}) genutzt wird,
wobei das am Verbindungspunkt der beiden Transistoren (T_{PNP}, T_{NPN}) entstehende Signal das Steuersignal für den auf dem hohen Potential liegenden Schalter (S_{high}) des Wechselrichters (2) bildet.

6. Schaltungsanordnung nach einem der Ansprüche 1 bis 5,
**dadurch gekennzeichnet,**
**dass** das transformierte Signal (Q) analog ist.

7. Schaltungsanordnung nach einem der Ansprüche 1 bis 5,
**dadurch gekennzeichnet,**
**dass** das transformierte Signal (Q) digital ist.

8. Schaltungsanordnung nach einem der vorherigen Ansprüche,
**dadurch gekennzeichnet,**
**dass** der Kondensator (C_{cap}) in der ersten Betriebsphase mit einem Speicherkondensator (C11, C12) verbunden ist, welcher durch den Stromfluß aufgeladen wird und eine Niedervoltversorgungsquelle bildet.

9. Schaltungsanordnung nach Anspruch 8,
**dadurch gekennzeichnet,**
**dass** zwei Speicherkondensatoren (C11, C12) vorgesehen sind, welche zu beiden Seiten des Kondensators (C_{cap}) angeordnet sind und eine auf einem hohen Bezugspotential liegende sowie eine auf einem niedrigen Bezugspotential liegende Niedervoltversorgungsquelle bilden.

10. Schaltungsanordnung nach Anspruch 8 oder 9,
**dadurch gekennzeichnet,**
**dass** parallel zu dem bzw. den Speicherkondensator(en) jeweils eine Z-Diode (D15, D16) angeordnet ist.

11. Schaltungsanordnung nach Anspruch 10,
**dadurch gekennzeichnet,**
**dass** diese Bestandteil eines elektronischen Vorschaltgeräts zum Betreiben einer Gasentladungslampe (LA) ist.

12. Verfahren zum Ansteuern eines Wechselrichters (2), der zumindest einen auf einem hohen Potential liegenden ersten Schalter (S_{high}) sowie einen auf einem-niedrigen Potential liegenden zweiten Schalter (S_{low}) aufweist, wobei ein Verbindungspunkt zwischen beiden Schaltern (S_{high}, S_{low}) den Ausgang des Wechselrichters (2) bildet,
wobei
a)ein Kondensator (C_{cap}) in einer ersten Betriebsphase derart mit dem Ausgang des Wechselrichters (2) verbunden wird, dass er in einem Zustand, in dem beide Schalter (S_{high}, S_{low}) des Wechselrichters (2) geöffnet sind, einen Stromfluß ermöglicht, und
b)der Kondensator (C_{cap}) in einer zweiten Betriebsphase hochohmig mit dem Wechselrichterausgang verbunden wird, so dass ein an einer Seite des Kondensators (C_{cap}) von einer Steuereinrichtung angelegtes Steuersignal (Q) auf ein höheres Potential transformiert wird, welches transformierte Signal als Steuersignal für den Wechselrichter (2) nutzbar ist.

13. Verfahren nach Anspruch 12,
**dadurch gekennzeichnet,**
**dass** das transformierte Signal (Q) unmittelbar zum Ansteuern des auf dem hohen Potential liegenden Schalters (S_{high}) des Wechselrichters (2) genutzt wird.

14. Verfahren nach Anspruch 12 oder 13,
**dadurch gekennzeichnet,**
**dass** das transformierte Signal (Q) analog ist.

15. Verfahren nach einem der Ansprüche 12 bis 14,
**dadurch gekennzeichnet,**
**dass** das transformierte Signal (Q) digital ist.

## Claims

1. Circuitry arrangement (1) for producing or transmitting control signals (Q) for an inverter (2) which has at least a first switch (S_{high}) lying at a high potential and a second switch (S_{low}) lying at a low potential, wherein a connection point between the two switches (S_{high}, S_{low}) forms the output of the inverter (2),
and wherein the circuitry arrangement (1) has a capacitor (C_{cap}) which
a) in a first operating phase is so connected via switching elements (S1-S4) with the output of the inverter (2) that in a condition in which the two switches (S_{high}, S_{low}) of the inverter (2) are open, it makes possible a current flow, and
**characterised in that**
b) in a second operating phase the capacitor is connected via the switching elements (S1-S4) to the inverter output in a high-impedance manner so that a control signal (Q) applied by a control device on one side of the capacitor (C_{cap}) is transformed to a higher potential.

2. Circuitry arrangement according to claim 1,
**characterised in that**
at least one of the switching elements (S1-S4) is formed by a diode (D11-D14) or a Zener diode.

3. Circuitry arrangement (1) for producing or transmitting control signals (Q) for an inverter (2) which has at least a first switch (S_{high}) lying at a high potential and a second switch (S_{low}) lying at a low potential, wherein a connection point between the two switches (S_{high}, S_{low}) forms the output of the inverter (2), and wherein the circuitry arrangement (1) has a capacitor (C_{cap}) which
a) in a first operating phase is so connected via switching elements (S1-S4) with the output of the inverter (2) that in a condition in which the two switches (S_{high}, S_{low}) of the inverter (2) are open, it makes possible a current flow, and
**characterised in that**
b) in a second operating phase the capacitor is connected via the switching elements (S1-S4) to the inverter output in a high-impedance manner so that a control signal (Q) applied by a control device on one side of the capacitor (C_{cap}) is transformed to a higher potential, which transformed signal is useable as a control signal for the inverter (2), and
**in that** at least one of the switching elements (S1-S4) is formed by a diode (D11-D14) or a Zener diode.

4. Circuitry arrangement according to any preceding claim,
**characterised in that**
the transformed signal (Q) is used directly for controlling the switch (S_{high}) of the inverter (2) lying at the high potential.

5. Circuitry arrangement according to any of claims 1 to 3,
**characterised in that**
the signal formed at the terminal of the capacitor (C_{cap}) lying at the higher potential is used for controlling a series circuit consisting of a PNP transistor (T_{PNP}) and an NPN transistor (T_{NPN}),
wherein the signal arising at the connection point of the two transistors (T_{PNP}, T_{NPN}) forms the control signal for the switch (S_{high}) of the inverter (2) lying at the high potential.

6. Circuitry arrangement according to any of claims 1 to 5,
**characterised in that**
the transformed signal (Q) is analog.

7. Circuitry arrangement according to any of claims 1 to 5,
**characterised in that**
the transformed signal (Q) is digital.

8. Circuitry arrangement according to any preceding claim,
**characterised in that**
in the first operating phase the capacitor (C_{cap}) is connected with a storage capacitor (C11, C12) which is charged by the current flow and forms a low-voltage supply source.

9. Circuitry arrangement according to claim 8,
**characterised in that**
two storage capacitors (C11, C12) are provided which are arranged to the two sides of the capacitor (C_{cap}) and form a low-voltage supply source lying at a high reference potential and a low-voltage supply source lying at a low reference potential.

10. Circuitry arrangement according to claim 8 or 9,
**characterised in that**
in each case a Zener diode (D15, D16) is arranged parallel to the storage capacitor(s).

11. Circuitry arrangement according to claim 10,
**characterised in that**
it is a component of an electronic ballast for operating a gas discharge lamp (LA).

12. Method of controlling an inverter (2) which has at least a first switch (S_{high}) lying at a high potential and a second switch (S_{low}) lying at a low potential, wherein a connection point between the two switches (S_{high}, S_{low}) forms the output of the inverter (2),
wherein
a) a capacitor (C_{cap}) in a first operating phase is so connected with the output of the inverter (2) that in a condition in which the two switches (S_{high}, S_{low}) of the inverter (2) are open, it makes possible a current flow, and
b) in a second operating phase the capacitor (C_{cap}) is connected to the inverter output in a high-impedance manner so that a control signal (Q) applied by a control device on one side of the capacitor (C_{cap}) is transformed to a higher potential, which transformed signal is useable as a control signal for the inverter (2).

13. Method according to claim 12,
**characterised in that**
the transformed signal (Q) is used directly for controlling the switch (S_{high}) of the inverter (2) lying at the high potential.

14. Method according to claim 12 or 13,
**characterised in that**
the transformed signal (Q) is analog.

15. Method according to any of claims 12 to 14,
**characterised in that**
the transformed signal (Q) is digital.

## Revendications

1. Configuration de circuit (1) pour générer ou transmettre des signaux de commande (Q) pour un onduleur (2), qui présente au moins un premier commutateur (Shigh) se trouvant à un potentiel haut ainsi qu'un deuxième commutateur (Slow) se trouvant à un potentiel bas, un point de jonction entre les deux commutateurs (Shigh, Slow) constituant la sortie de l'onduleur (2),
et la configuration de circuit (1) présentant un condensateur (Ccap), lequel
a) dans une première phase de fonctionnement, est connecté à la sortie de l'onduleur (2) par l'intermédiaire d'éléments de commutation (S1-S4) de telle façon que, dans un état dans lequel les deux commutateurs (Shigh, Slow) de l'onduleur (2) sont ouverts, il permette une circulation du courant, et **caractérisée en ce que**
b) dans une deuxième phase de fonctionnement, le condensateur est connecté à haute impédance avec la sortie de l'onduleur par l'intermédiaire des éléments de commutation (S1-S4) de telle sorte qu'un signal de commande (Q) appliqué par une unité de commande à un côté du condensateur (Ccap) est transformé en un potentiel plus haut.

2. Configuration de circuit selon la revendication 1,
**caractérisée en ce que**
au moins un des éléments de commutation (S1-S4) est constitué d'une diode (D11-D14) ou d'une diode Zener.

3. Configuration de circuit (1) pour générer ou transmettre des signaux de commande (Q) pour un onduleur (2), qui présente au moins un premier commutateur (Shigh) se trouvant à un potentiel haut ainsi qu'un deuxième commutateur (Slow) se trouvant à un potentiel bas, un point de jonction entre les deux commutateurs (Shigh, Slow) constituant la sortie de l'onduleur (2),
et la configuration de circuit (1) présentant un condensateur (Ccap), lequel
a) dans une première phase de fonctionnement, est connecté à la sortie de l'onduleur (2) par l'intermédiaire d'éléments de commutation (S1-S4) de telle façon que, dans un état dans lequel les deux commutateurs (Shigh, Slow) de l'onduleur (2) sont ouverts, il permette une circulation du courant, et **caractérisée en ce que**
b) dans une deuxième phase de fonctionnement, le condensateur est connecté à haute impédance avec la sortie de l'onduleur par l'intermédiaire des éléments de commutation (S1-S4) de telle sorte qu'un signal de commande (Q) appliqué par une unité de commande à un côté du condensateur (Ccap) est transformé en un potentiel plus haut, lequel signal transformé est utilisable comme signal de commande pour l'onduleur (2), et
**en ce que** au moins un des éléments de commutation (S1-S4) est constitué d'une diode (D11-D14) ou d'une diode Zener.

4. Configuration de circuit selon l'une des revendications précédentes,
**caractérisée en ce que**
le signal transformé (Q) est utilisé directement pour commander le commutateur (Shigh) de l'onduleur (2) se trouvant au potentiel haut.

5. Configuration de circuit selon l'une des revendications 1 à 3,
**caractérisée en ce que**
le signal fourni au branchement du condensateur (Ccap) se trouvant sur le potentiel haut est utilisé pour commander un circuit série composé d'un transistor PNP (TPNP) et d'un transistor NPN (TNPN),
le signal résultant au point de jonction des deux transistors (TPNP, TNPN) constitue le signal de commande pour le commutateur (Shigh) de l'onduleur (2) se trouvant au potentiel haut.

6. Configuration de circuit selon l'une des revendications 1 à 5,
**caractérisée en ce que**
le signal transformé (Q) est analogue.

7. Configuration de circuit selon l'une des revendications 1 à 5,
**caractérisée en ce que**
le signal transformé (Q) est numérique.

8. Configuration de circuit selon l'une des revendications précédentes,
**caractérisée en ce que**
le condensateur (Ccap) est connecté dans la première phase de fonctionnement avec un condensateur de stockage (C11, C12), lequel est chargé par le courant électrique et constitue une source d'alimentation à bas voltage.

9. Configuration de circuit selon la revendication 8,
**caractérisée en ce que**
deux condensateurs de stockage (C11, C12) sont prévus, lesquels sont disposés de chaque côté du condensateur (Ccap) et constituent une source d'alimentation à bas voltage se trouvant sur un niveau de potentiel haut ainsi que sur un niveau de potentiel bas.

10. Configuration de circuit selon la revendication 8 ou 9,
**caractérisée en ce que**
une diode Zener (D15, D16) est respectivement disposée parallèlement au ou aux condensateur(s) de stockage.

11. Configuration de circuit selon la revendication 10,
**caractérisée en ce que**
elle fait partie d'un ballast électronique pour faire fonctionner une lampe à décharge de gaz (LA).

12. Procédé pour commander un onduleur (2) qui présente au moins un premier commutateur (Shigh) se trouvant à un potentiel haut ainsi qu'un deuxième commutateur (Slow) se trouvant à un potentiel bas, un point de jonction entre les deux commutateurs (Shigh, Slow) constituant la sortie de l'onduleur (2),
dans lequel
a) un condensateur (Ccap) est connecté dans une première phase de fonctionnement à la sortie de l'onduleur (2) de telle façon que, dans un état dans lequel les deux commutateurs (Shigh, Slow) de l'onduleur (2) sont ouverts, il permette une circulation du courant, et
b) le condensateur (Ccap) est connecté dans une deuxième phase de fonctionnement à haute impédance avec la sortie de l'onduleur de telle sorte qu'un signal de commande (Q) appliqué par une unité de commande à un côté du condensateur (Ccap) est transformé en un potentiel plus haut, lequel signal transformé est utilisable comme signal de commande pour l'onduleur (2).

13. Procédé selon la revendication 12,
**caractérisé en ce que**
le signal transformé (Q) est utilisé directement pour commander le commutateur (Shigh) de l'onduleur (2) se trouvant au potentiel haut.

14. Procédé selon la revendication 12 ou 13,
**caractérisé en ce que**
le signal transformé (Q) est analogique.

15. Procédé selon l'une des revendications 12 à 14,
**caractérisé en ce que**
le signal transformé (Q) est numérique.
